# EUROPÄISCHE PATENTSCHRIFT

(11) **EP 3 013 837 B1**
(45) Veröffentlichungstag und Bekanntmachung des Hinweises auf die Patenterteilung: **31.05.2017**
(21) Anmeldenummer: 14721312.8
(22) Anmeldetag: 28.04.2014
(51) Int. Cl.: C07F 5/00, C23C 18/12, H01L 21/285, C23C 18/14, H01L 21/02

(54) **FORMULIERUNGEN ZUR HERSTELLUNG INDIUMOXID-HALTIGER SCHICHTEN, VERFAHREN ZU IHRER HERSTELLUNG UND IHRE VERWENDUNG**
FORMULATIONS FOR PRODUCING INDIUM OXIDE-CONTAINING LAYERS, METHODS FOR PRODUCING SAID LAYERS AND THE USE THEREOF
FORMULATIONS POUR LA PRODUCTION DE COUCHES CONTENANT DE L'OXYDE D'INDIUM, PROCÉDÉ POUR LA PRODUCTION DESDITES FORMULATIONS ET L'UTILISATION DESDITES FORMULATIONS

(30) Priorität: 25.06.2013 DE 102013212019
(43) Veröffentlichungstag der Anmeldung: 04.05.2016
(73) Patentinhaber: Evonik Degussa GmbH, 45128 Essen (DE)
(72) Erfinder: STEIGER, Jürgen, 111 Taipei City (TW); MERKULOV, Alexey, 45665 Recklinghausen (DE); HOPPE, Arne, 45136 Essen (DE)
(86) Internationale Anmeldenummer: PCT/EP2014/058615
(87) Internationale Veröffentlichungsnummer: WO 2014/206599

(56) Entgegenhaltungen:
- WO-A1-2011/072887
- DE-A1-102010 031 592

## Beschreibung

Die vorliegende Erfindung betrifft Formulierungen zur Herstellung Indiumoxid-haltiger Schichten, Verfahren zu ihrer Herstellung und ihre Verwendung.

Die Herstellung halbleitender elektronischer Bauteilschichten über Druck- und andere flüssige Abscheidungsprozesse ermöglicht im Vergleich zu vielen anderen Verfahren, wie z.B. Chemical Vapor Deposition (CVD), weitaus niedrigere Produktionskosten, da die Deposition des Halbleiters hier in einem kontinuierlichen Prozess erfolgen kann. Darüber hinaus eröffnet sich im Falle niedrigerer Prozesstemperaturen die Möglichkeit, auch auf flexiblen Substraten zu arbeiten, und gegebenenfalls (vor allem im Falle sehr dünner Schichten und insbesondere bei oxidischen Halbleitern) eine optische Transparenz der gedruckten Schichten zu erreichen. Unter halbleitenden Schichten sind hier und im folgenden Schichten zu verstehen, die Ladungsträgerbeweglichkeiten von 1 bis 50 cm²/Vs bei einem Bauteil mit einer Kanallänge von 20 µm bei 50 V Gate-Source-Spannung und 50 V Source-Drain-Spannung aufweisen.

Da das Material der über Druckverfahren herzustellenden Bauteilschicht die jeweiligen Schichteigenschaften maßgeblich bestimmt, hat seine Wahl einen bedeutsamen Einfluss auf jedes diese Bauteilschicht enthaltende Bauteil. Wichtige Parameter für gedruckte Halbleiter-schichten sind ihre jeweiligen Ladungsträgerbeweglichkeiten sowie die Verarbeitbarkeiten und Verarbeitungstemperaturen der bei ihrer Herstellung eingesetzten verdruckbaren Vorstufen. Die Materialien sollten eine gute Ladungsträgerbeweglichkeit aufweisen und aus Lösung und bei Temperaturen deutlich unter 500 °C herstellbar sein, um für eine Vielzahl von Anwendungen und Substraten geeignet zu sein. Ebenfalls wünschenswert für viele neuartige Anwendungen ist eine optische Transparenz der erzeugten halbleitenden Schichten.

Indiumoxid (Indium(III)oxid, In₂O₃) ist aufgrund der großen Bandlücke zwischen 3.6 und 3.75 eV (gemessen für aufgedampfte Schichten, H.S. Kim, P.D. Byrne, A. Facchetti, T.J. Marks; J. Am. Chem. Soc. 2008, 130, 12580-12581) ein vielversprechender und somit gerne eingesetzter Halbleiter. Dünne Filme von wenigen hundert Nanometern Dicke können darüber hinaus eine hohe Transparenz im sichtbaren Spektralbereich von größer als 90 % bei 550 nm aufweisen. In extrem hoch geordneten Indiumoxid-Einkristallen kann man zudem Ladungsträgerbeweglichkeiten von bis zu 160 cm²/Vs messen. Bislang können jedoch solche Werte durch Prozessierung aus Lösung noch nicht erreicht werden (H. Nakazawa, Y. Ito, E. Matsumoto, K. Adachi, N. Aoki, Y. Ochiai; J. Appl. Phys. 2006, 100, 093706. und A. Gupta, H. Cao, Parekh, K.K.V. Rao, A.R. Raju, U.V. Waghmare; J. Appl. Phys. 2007, 101, 09N513).

Indiumoxid wird oft vor allem zusammen mit Zinn(IV)-oxid (SnO₂) als halbleitendes Mischoxid ITO eingesetzt. Aufgrund der verhältnismäßig hohen Leitfähigkeit von ITO-Schichten bei gleichzeitiger Transparenz im sichtbaren Spektralbereich findet es unter anderem Anwendung im Bereich von Flüssigkristallbildschirmen (LCD; liquid crystal display), insbesondere als "durchsichtige Elektrode". Diese zumeist dotierten Metalloxid-Schichten werden industriell vor allem durch kostenintensive Aufdampfmethoden im Hochvakuum hergestellt. Aufgrund des großen wirtschaftlichen Interesses an ITO-beschichteten Substraten existieren mittlerweile einige, vor allem auf Sol-Gel-Techniken beruhende Beschichtungsverfahren für Indiumoxidhaltige Schichten.

Prinzipiell gibt es zwei Möglichkeiten für die Herstellung von Indiumoxid-Halbleitern über Druckverfahren: 1) Partikel-Konzepte, bei denen (Nano)Partikel in verdruckbarer Dispersion vorliegen und nach dem Druckvorgang durch Sintervorgänge in die gewünschte Halbleiterschicht konvertiert werden, sowie 2) Precursor-Konzepte, bei denen mindestens ein lösliches oder dispergierbares Vorprodukt nach dem Verdrucken einer entsprechenden Zusammensetzung zu einer Indiumoxid-haltigen Schicht umgesetzt wird. Das Partikelkonzept hat zwei bedeutende Nachteile gegenüber dem Einsatz von Precursoren: Zum einen weisen die Partikel-Dispersionen eine kolloidale Instabilität auf, die die Anwendung von (in Bezug auf die späteren Schichteigenschaften nachteiligen) Dispergieradditiven erforderlich macht, zum anderen bilden viele der einsetzbaren Partikel (z.B. aufgrund von Passivierungsschichten) nur unvollständig Schichten durch Sinterung aus, so dass in den Schichten teilweise noch partikuläre Strukturen vorkommen. An deren Partikelgrenze kommt es zu einem erheblichen Partikel-Partikel-Widerstand, welcher die Beweglichkeit der Ladungsträger verringert und den allgemeinen Schichtwiderstand erhöht.

Es gibt verschiedene Precursor-haltige Formulierungen für die Herstellung von Indiumoxid-Schichten. So können neben Indiumsalzen Indium-Alkoxide (homoleptische, d.h. nur Indium und Alkoxid-Reste aufweisende Verbindungen) als Precursoren in Lösung für die Herstellung von Indiumoxid-haltigen Schichten eingesetzt werden.

Zum Beispiel beschreiben Marks et al. Bauteile, bei deren Herstellung eine Precursor-haltige Zusammensetzung umfassend das Salz InCl₃ sowie der Base Monoethanolamin (MEA) gelöst in Methoxyethanol eingesetzt wird. Nach Aufschleudern (Spin-coating) der Zusammensetzung wird die entsprechende Indiumoxid-Schicht durch eine thermische Behandlung bei 400 °C erzeugt (H.S. Kim, P.D. Byrne, A. Facchetti, T.J. Marks; J. Am. Chem. Soc. 2008, 130, 12580-12581 and supplemental informations).

WO 2011/072887 A1 beschreibt ein Verfahren zur Herstellung von Indium(III)-halogen-dialkoxiden und deren Verwendung zur Herstellung Indiumoxid-haltiger Schichten. Verfahren zur Herstellung Indiumoxid-haltiger Schichten aus diesen Indium(III)-halogendialkoxiden werden in WO 2011/073005 A2 offenbart.

Indium(III)-halogendialkoxide führen jedoch bislang in Lösung nicht zu Indiumoxid-haltigen Schichten mit hinreichend guten elektrischen Eigenschaften. Zu besseren Schichteigenschaften führen Indiumoxoalkoxide, wie zum Beispiel die in WO 2012/010427 A1, WO 2012/010464 A1 und in der bislang nicht offen gelegten deutschen Anmeldung DE 10 2012 209918 offenbarten Verbindungen der generischen Formeln In₆O₂X₆(OR)₆(R'CH(O)COOR")₂(HOR)ₓ(HNR"'₂)_{y}, In₇O₂(OH)(OR)₁₂X₄(ROH)ₓ sowie MₓO_{y}(OR)_{z}[O(R'O)ₑH]ₐX_{b}Y_{c}[R"OH]_{d}.

Trotz der bereits bekannten Verbesserungen besteht ein beständiger Bedarf an Verbesserungen hinsichtlich der Schichtbildungseigenschaften und der Eigenschaften der erhaltenen Schichten. Insbesondere soll eine geeignete Precursor-haltige Lösung sich
- gut, insbesondere an Luft, verarbeiten lassen,
- homogen in das Oxid umwandeln,
- bei möglichst niedrigen Temperaturen in das Oxid umwandeln lassen und
- zu Schichten mit herausragenden elektrischen Eigenschaften führen.

Dieses komplexe Anforderungsprofil wird durch die erfindungsgemäße flüssige Formulierung erfüllt, die herstellbar ist durch Lösen mindestens einer durch Umsetzen
- eines Indiumtrihalogenids InX₃ mit X = F, Cl, Br, I
- mit einem sekundären Amin der Formel R'₂NH mit R' =Alkyl,
   ∘ im molaren Verhältnis von 8:1 bis 20:1 in Bezug auf das Indiumtrihalogenid
- in Gegenwart eines Alkohols der generischen Formel ROH mit R = Alkyl herstellbaren Indiumalkoxid-Verbindung in mindestens einem Lösemittel.

Besonders gute Schichten lassen sich mit Formulierungen enthaltend Indiumalkoxid-Verbindungen herstellen, bei deren Herstellung das sekundäre Amin bei der Umsetzung in einem molaren Verhältnis von 8:1 bis 15:1, noch besser in einem Verhältnis von 8:1 bis 12:1 in Bezug auf das Indiumtrihalogenid eingesetzt wurde.

Unter einer Indiumalkoxid-Verbindung im Sinne der vorliegenden Erfindung ist vorliegend eine mindestens ein Indiumatom und mindestens einen Alkoxid-Rest aufweisende Verbindung zu verstehen, die über die beschriebene Umsetzung des Trihalogenids mit dem sekundären Amin in Gegenwart eines Alkohols hergestellt werden kann. Die Bestimmung der Struktur dieser nach dem erfindungsgemäßen Verfahren erhältlichen gelösten Verbindungen ist schwierig. Es wird jedoch angenommen, dass die resultierenden Verbindungen halogenhaltige Indiumoxoalkoxid-Verbindungen sind. Entsprechende Festkörperstrukturen konnten über Röntgenstrukturanalysen ermittelt werden. Es wird angenommen, dass ähnliche Strukturen für diese Verbindungen auch in Lösung vorliegen. Bei Indiumoxoalkoxiden handelt es sich um ggf. in ionischer Form vorliegende, über Oxo-Reste verbrückte Indiumcluster, bei denen nicht mit Oxo-Resten koordinierte Valenzen zumindest zum Teil mit Alkoxidresten koordiniert sind. Für die nach dem erfindungsgemäßen Verfahren erhältlichen Indiumalkoxid-Verbindungen wird angenommen, dass diese nach der Synthese üblicherweise als Salz vorliegen, insbesondere als mit Kationen koordinierte halogenhaltige Indiumoxoalkoxid-Anionen.

Eine besonders bevorzugtes Verfahrensprodukt ist eine Indiumalkoxid-Verbindung der generischen Formel [In₆(O)(OR)₁₂X₆]²⁻Aₘ^{z} (ROH)ₓ mit R = Alkyl, X = F, Cl, Br, I, A = Kation, z = Wertigkeit des Kations, m·z = 2 und x = 0 bis 10, das sich u.a. bei Verwendung sekundärer Amine im Verhältnis von 9:1 bis 10:1 herstellen lässt. Die Verbindung kann mit Alkoholmolekülen ROH und ggf. auch mit anderen bei der Reaktion anwesenden Solventien koordiniert sein.

Typische Kationen sind Ammoniumionen [NH_{y}R_{4-y}]⁺, bevorzugt Ammoniumionen der Formel [NH₂R₂]⁺.

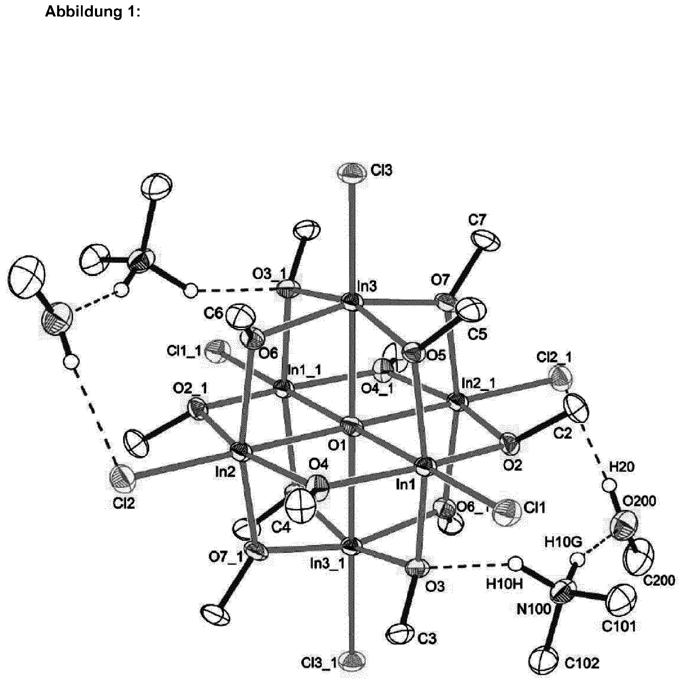

Eine ganz besonders bevorzugte Verbindung ist [In₆(O)(OMe)₁₂Cl₆]²⁻[NH₂R₂]⁺₂ (MeOH)₂, die durch Verwendung von InCl₃, Me₂NH (letzteres im Verhältnis von 9:1 bis 10:1) und MeOH (Methanol) hergestellt werden kann. Ihre über Röntgenstrukturanalyse ermittelte Struktur ist in Abbildung 1 dargestellt.

Die erfindungsgemäße Formulierung enthält die Indiumalkoxid-Verbindung zur Erzielung besonders guter Halbleiter-Schichten bevorzugt in Gewichtsprozentanteilen von 0,1 bis 10 Gew.-%, bevorzugt 0,5 - 5 Gew.-%, ganz besonders bevorzugt 1 - 2 Gew.-%, bezogen auf die Gesamtmasse der Formulierung.

Die erfindungsgemäße Formulierung weist weiterhin mindestens ein Lösemittel auf. Bevorzugt ist zur Erzielung besonders guter Formulierungen das mindestens eine Lösemittel ausgewählt aus der Gruppe bestehend aus primären, sekundären, tertiären und aromatischen Alkoholen (besonders bevorzugt sind die Alkohole Methanol, Ethanol, Butanol, Tetrahydrofurfurylalkohol und Phenol), der Ether (besonders bevorzugt sind Glykolether der Formel ROCH₂CH(R')OR" mit R = -H oder -C₁-C₁₀-Alkyl, R' = -H oder -CH₃ und R" = -H oder -C₁-C₁₀-Alkyl und cyclische Ether, insbesondere 2-Methoxyethanol, 1-Methoxy-2-propanol und Tetrahydrofuran, sowie Anisol), der Ester (besonders bevorzugt sind Carbonsäureester und Milchsäurealkylester, insbesondere Butylacetat, 1-Methoxy-2-propyl-acetat (PGMEA), Ethylbenzoat, Ethylenglycoldiacetat, Ethyllactat und Butyllactat), der aromatischen Kohlenwasserstoffe (besonders bevorzugt sind Toluol und Xylol) und der Nitrile (besonders bevorzugt ist Acetonitril).

Bevorzugt wird das mindestens eine Lösemittel ausgewählt aus der Gruppe bestehend aus Methanol, Ethanol, Butanol, Tetrahydrofurfurylalkohol, Phenol, 2-Methoxyethanol, 1-Methoxy-2-propanol, Tetrahydrofuran, Anisol, Butylacetat, 1-Methoxy-2-propyl-acetat (PGMEA), Ethylbenzoat, Ethylenglycoldiacetat, Ethyllactat, Butyllactat, Toluol, Xylol und Acetonitril.

Weiter bevorzugt weist die erfindungsgemäße Formulierung mindestens zwei, noch weiter bevorzugt mindestens drei Lösemittel ausgewählt aus der Gruppe der zuvor genannten Lösemittelklassen auf.

Bevorzugt weist die erfindungsgemäße Formulierung mindestens drei Lösemittel auf, von denen eines ausgewählt wird aus der Gruppe bestehend aus Ethyllactat, Anisol, Tetrahydrofurfurylalkohol, Butylacetat, Ethylenglycoldiacetat und Ethylbenzoat und die anderen beiden unter SATP-Bedingungen eine Siedepunktsdifferenz von mindestens 30 °C aufweisen. Mit entsprechenden Formulierungen können besonders gute Ergebnisse erzielt werden.

Die besten Ergebnisse können erzielt werden mit einer Formulierung umfassend die drei Lösemittel Ethanol, 1-Methoxy-2-propanol und Tetrahydrofurfurylalkohol.

Die Erfindung enthält das oder die Lösemittel bevorzugt in Gewichtsprozentanteilen von 90 - 99,9 Gew.-%, bevorzugt 95 - 99,5 Gew.-%, besonders bevorzugt 98 - 99 Gew.-% bezogen auf die Gesamtmasse der Beschichtungszusammensetzung.

Weiterhin kann die erfindungsgemäße Zusammensetzung zur Erzielung vorteilhafter Eigenschaften Additive, insbesondere Benetzungsadditive (insbesondere Tenside), Entschäumer, Vernetzungsadditive, Oberflächenspannungsadditive und Verlaufsadditive aufweisen. Sind Additive anwesend, beträgt ihr Gewichtsprozentanteil, bezogen auf die Gesamtmasse an Beschichtungszusammensetzung weniger als 5 Gew.-%, bevorzugt weniger als 2 Gew.-%. Bevorzugt weist die erfindungsgemäße Zusammensetzung jedoch keine weiteren Additive auf, d.h. sie wurde ausschließlich unter Verwendung des oder der Lösemittel und der Indiumalkoxid-Verbindung(en) hergestellt.

Zur Erzielung besonders guter Eigenschaften ist die Formulierung im Wesentlichen wasserfrei, d.h. sie weist weniger als 200 ppm H₂O auf. Weiterhin wurde die Formulierung weiter bevorzugt auch durch Verwendung im Wesentlichen wasserfreier Lösemittel und Verbindungen hergestellt.

Gegenstand der vorliegenden Erfindung ist weiterhin ein Verfahren zur Herstellung der erfindungsgemäßen Formulierung, bei dem mindestens eine der genannten Indiumalkoxid-Verbindungen mit mindestens einem Lösemittel vermischt wird.

Die zur Herstellung der erfindungsgemäßen Formulierung eingesetzten Indiumalkoxid-Verbindungen werden hergestellt über ein Verfahren, bei dem
- ein Indiumtrihalogenid InX₃ mit X = F, Cl, Br, I
- mit einem sekundären Amin der Formel R'₂NH mit R' =Alkyl,
   ∘ im molaren Verhältnis von 8:1 bis 20:1 in Bezug auf das Indiumtrihalogenid
- in Gegenwart eines Alkohols der generischen Formel ROH mit R = Alkyl umgesetzt wird.

Indiumtrihalogenide der Formel InX₃ sind dem Fachmann bekannt und können käuflich erworben werden.

Sekundäre Amine der Formel R'₂NH mit R' =Alkyl gehören ebenfalls zum Stand der Technik. Bevorzugt handelt es sich bei dem Alkylrest R' um einen linearen, verzweigten oder cyclischen C₁- bis C₁₀-Alkylrest der Formel CₙH₂ₙ₊₁ mit n = 1 bis 10. Zwei Reste R' eines oder zweier verschiedener sekundärer Amine können auch gemeinsam einen Alkylenrest CₙH₂ₙ bilden. Entsprechend einsetzbare Verbindungen sind z.B. Dimethylamin, Diethylamin, Dipropylamin, Pyrrolidin, Piperidin und Pyrrol. Bevorzugte Reste R' sind die Reste Methyl, Ethyl, n-Propyl und i-Propyl. Ganz bevorzugt ist der Rest R' Methyl, da dies zu besonders guten Ausbeuten und besonders stabilen Verbindungen führt.

Als Alkohol ROH werden bevorzugt solche mit linearen, verzweigten oder cyclischen C₁- bis C₁₀-Alkylresten der Formel CₙH₂ₙ₊₁ mit n = 1 bis 10 eingesetzt. Bevorzugte Reste R sind auch hier Methyl, Ethyl, n-Propyl und i-Propyl. Ganz bevorzugt sind die Reste R Methyl.

Das Indiumtrihalogenid wird bei dem Verfahren bevorzugt in Anteilen von 0,1 bis 50 Gew.-%, besonders bevorzugt 1 bis 25 Gew.-%, ganz besonders bevorzugt 2 bis 10 Gew.-% bezogen auf die Gesamtmasse aller Komponenten eingesetzt.

Das Indiumtrihalogenid kann gelöst, d.h. dissoziiert bzw. auf molekularer Ebene komplexiert mit Lösemittelmolekülen/Alkoholmolekülen, oder in flüssiger Phase dispergiert werden.

Der Alkohol ROH wird bei dem Verfahren bevorzugt in Anteilen von 50 bis 99,9 Gew.-%, besonders bevorzugt 75 bis 99 Gew.-%, ganz besonders bevorzugt 80 bis 96 Gew.-% bezogen auf die Gesamtmasse aller Komponenten eingesetzt.

Das Reaktionsgemisch des Verfahrens kann weiterhin mindestens ein in Bezug auf die Reaktion inertes flüssiges Lösemittel bzw. Dispersionsmedium, d.h. ein Lösemittel/Dispersionsmedium oder ein Gemisch verschiedener Lösemittel/Dispersionsmedien, die unter den Reaktionsbedingungen nicht mit den Indiumtrihalogeniden reagieren, aufweisen.

Vorzugsweise einsetzbar sind aprotische Lösemittel, insbesondere solche ausgewählt aus der Gruppe der aprotischen unpolaren Lösemittel, d.h. der Alkane, substituierten Alkane, Alkene, Alkine, Aromaten ohne oder mit aliphatischen oder aromatischen Substituenten, halogenierten Kohlenwasserstoffe und Tetramethylsilan, und der Gruppe der aprotischen polaren Lösemittel, d.h. der Ether, aromatischen Ether, substituierten Ether, Ester oder Säureanhydride, Ketone, tertiäre Amine, Nitromethan, DMF (Dimethylformamid), DMSO (Dimethylsulfoxid) oder Propylencarbonat.

Liegt mindestens ein solches in Bezug auf die Reaktion inertes flüssiges Lösemittel bzw. Dispersionsmedium in dem Reaktionsgemisch vor, beträgt sein Anteil bevorzugt 1 bis 50 Gew.-%, besonders bevorzugt 1 bis 25 Gew.-%, ganz besonders bevorzugt 1 bis 10 Gew.-% bezogen auf die Gesamtmasse aller Komponenten.

Bevorzugt wird das sekundäre Amin bei der Umsetzung in einem molaren Verhältnis von 8:1 bis 15:1, noch besser in einem Verhältnis von 8:1 bis 12:1 in Bezug auf das Indiumtrihalogenid eingesetzt, weil dann in besonders hoher Ausbeute besonders gut für die Schichtherstellung geeignete Indiumalkoxid-Verbindungen hergestellt werden können.

Bevorzugt wird das erfindungsgemäße Verfahren so durchgeführt, dass Indiumtrihalogenid in Alkohol ROH vorgelegt wird. Das sekundäre Amin wird gasförmig, flüssig oder in Lösemittel gelöst (umfassend insbesondere ROH als Lösemittel) zugegeben.

Ebenfalls bevorzugt erfolgt die Zugabe bei SATP-Bedingungen (25 °C und 1,013 bar).

Da die Reaktion so besonders gut steuerbar ist und zu besonders guten Indiumalkoxid-Verbindungen führt, wird das Dialkylamin bevorzugt mit einer Geschwindigkeit von 0,5 bis 5 Mol pro Stunde und Mol Indiumhalogenid, bevorzugt 1,15 bis 2,60 Mol pro Stunde und Mol Indiumhalogenid zugegeben.

Weiter bevorzugt wird das Reaktionsgemisch bei dem Verfahren nach Zugabe aller Komponenten erwärmt. Bevorzugt wird das Reaktionsgemisch über eine Zeit von 1 bis 10 h auf eine Temperatur zwischen 40 und 70 °C erwärmt. Weiter bevorzugt wird das Reaktionsgemisch über eine Zeit von 1 bis 5 h auf eine Temperatur zwischen 45 und 60 °C erwärmt. Danach wird das Reaktionsgemisch abgekühlt.

Nach Beendigung der Reaktion wird das Produkt bzw. Produktgemisch, das üblicherweise ausfällt, bevorzugt von den übrigen Bestandteilen der Reaktionszusammensetzung separiert. Bevorzugt erfolgt dies über Filtration. Bevorzugt wird das separierte Produktgemisch weiterhin mit geeigneten Lösemitteln getrocknet und gewaschen.

Besonders gute zur Herstellung der erfindungsgemäßen Formulierungen einsetzbare Indiumalkoxid-Verbindungen resultieren, wenn das erhaltene Produkt bzw. das erhaltene Produktgemisch nach Separation und ggf. erfolgter Trocknung und/oder Waschung rekristallisiert wird. Bevorzugt wird die Rekristallisation in dem Alkohol ROH durchgeführt, der auch bei der Synthese der Verbindung eingesetzt wurde. Bevorzugt wird die Rekristallisation so durchgeführt, dass das isolierte Produkt bzw. Produktgemisch in siedendem Alkohol gelöst und anschließend bei Temperaturen von -30 bis 0 °C auskristallisiert wird. Das überstehende Lösemittel wird verworfen und das kristalline Produkt kann für die weitere Verwendung eingesetzt werden.

Die erfindungsgemäßen Formulierungen eignen sich besonders vorteilhaft zur Herstellung Indiumoxid-haltiger Beschichtungen mit verbesserten elektrischen Eigenschaften, insbesondere über nasschemische Verfahren. Diese Verbesserung ist insofern überraschend, da man für Precursoren von Metalloxiden im Allgemeinen nach Substanzen sucht, die über eine möglichst geringe Kristallisationsneigung verfügen. Die erfindungsgemäßen Verbindungen stellen jedoch vielfach Clusterverbindungen dar, die somit schon eine Mikrokristallitstruktur aufweisen. Die gewünschte Metalloxidschicht sollte auch eher einen amorphen als einen kristallinen Charakter aufweisen, um über besonders gute elektrische Eigenschaften zu verfügen. Entgegen der Erwartung können mit der erfindungsgemäßen Verbindung Schichten hergestellt werden, die besonders homogen sind.

Unter Indiumoxid-haltigen Beschichtungen sind in diesem Falle sowohl Indiumoxid-Schichten als auch Schichten im Wesentlichen umfassend Indiumoxid und weitere Metalle und/oder Metalloxide zu verstehen. Unter einer Indiumoxid-Schicht im Sinne der vorliegenden Erfindung ist dabei eine aus den erwähnten Indiumalkoxiden herstellbare, metallhaltige Schicht zu verstehen, die im Wesentlichen Indiumatome bzw. -ionen aufweist, wobei die Indiumatome bzw. -ionen im Wesentlichen oxidisch vorliegen. Gegebenenfalls kann die Indiumoxid-Schicht auch noch Halogen- bzw. Alkoxid-Anteile aus einer nicht vollständigen Konvertierung und/oder Stickstoff, Wasserstoff und/oder Kohlenstoff aufweisen. Entsprechendes gilt auch für Schichten im Wesentlichen umfassend Indiumoxid und weitere Metalle und/oder Metalloxide, mit der Maßgabe, dass diese weiterhin die weiteren Metalle und/oder Metalloxide aufweist.

Die erfindungsgemäßen Formulierungen haben weiterhin den überraschenden Vorteil, dass diese besonders gut für die Herstellung leitender oder halbleitender Indiumoxid-haltiger Schichten für elektronische Bauteile, insbesondere bei der Herstellung von (Dünnschicht)Transistoren, Dioden oder Solarzellen, eingesetzt werden können.

Gegenstand der vorliegenden Erfindung ist weiterhin auch ein Verfahren zur Herstellung Indiumoxid-haltiger Schichten, bei dem eine erfindungsgemäße Formulierung auf ein (ggf. vorbeschichtetes oder vorbehandeltes) Substrat aufgebracht, ggf. getrocknet und mit Wärme und/oder elektromagnetischer Strahlung konvertiert wird.

Das Substrat, das bei diesen erfindungsgemäßen Verfahren eingesetzt wird, ist bevorzugt ein Substrat ausgewählt aus Substraten bestehend aus Glas, Silicium, Siliciumdioxid, einem Metall-oder Übergangsmetalloxid oder einem polymeren Material, insbesondere PE, PEN, PI oder PET.

Nach der Beschichtung und vor der Konvertierung kann das beschichtete Substrat weiterhin getrocknet werden. Entsprechende Maßnahmen und Bedingungen hierfür sind dem Fachmann bekannt. Das beschichtete Substrat muss jedoch nicht zwangsweise vor der Konvertierung getrocknet werden.

Besonders gut geeignet sind die erfindungsgemäßen Zusammensetzungen für den Einsatz bei Beschichtungsverfahren ausgewählt aus Druckverfahren (insbesondere Flexo/Gravur-Druck, Inkjet-Druck, (Reverse) Offset-Druck, digitalem Offset-Druck und Siebdruck), Sprühverfahren ("Spray Coating"), Rotationsbeschichtungsverfahren ("Spin-coating"), Tauchverfahren ("Dipcoating") und anderen Flüssigphasenbeschichtungsverfahren wie Slot-Die-Coating-, Slit-Coating-, Curtain-Coating- und Doctorblading-Verfahren.

Die Konvertierung der erzeugten Struktur bzw. Schicht zu Indiumoxid bzw. einer Indiumoxid-haltigen Schicht bzw. Struktur kann auf thermischem Wege und/oder durch UV-, IR- oder VIS-Strahlung erfolgen.

Besonders gute Ergebnisse können jedoch erzielt werden, wenn zur Konvertierung Temperaturen von 20 °C bis 550 °C, bevorzugt 100 bis 400 °C, besonders bevorzugt 150 bis 350 °C eingesetzt werden.

Weiterhin kann die aufgebrachte Formulierung alternativ oder ergänzend auch mit elektromagnetischer Strahlung, insbesondere mit UV-Strahlung konvertiert werden. Bevorzugt ist dabei die Konvertierung mit elektromagnetischer Strahlung einer Wellenlänge zwischen 160 und 300 nm. Bevorzugt kann die Konvertierung mit UVO-Strahlung mit signifikanten Strahlungsanteilen von 250 bis 258 und 180 bis 190 nm erfolgen, wie sie z.B. mit bestimmten Quecksilberdampflampen erzeugt werden kann. Auch möglich ist die Konvertierung mit Strahlung einer Excimer-Lampe oder eines Excimer-Lasers, insbesondere mit Strahlung einer Wellenlänge zwischen 160 und 190 nm.

Besonders gute Schichten resultieren, wenn die aufgebrachte Formulierung mit Wärme (insbesondere einer Temperatur von 100 bis 400 °C, besonders bevorzugt 150 bis 350 °C) und mit elektromagnetischer Strahlung (insbesondere elektromagnetischer Strahlung einer Wellenlänge zwischen 160 und 300 nm) konvertiert wird.

Dabei werden typischerweise Konvertierungszeiten von einigen Sekunden bis hin zu mehreren Stunden verwendet. Konvertierungszeiten betragen typischerweise 1 s bis 24 h, bevorzugt 10 s bis 2 h, weiter bevorzugt 1 Minute bis 40 Minuten, besonders bevorzugt 1 Minute bis 20 Minuten.

Die Konvertierung kann weiterhin dadurch unterstützt werden, dass die nach dem Beschichtungsschritt erhaltene Schicht vor der thermischen Behandlung in Kontakt mit Wasser und/oder Wasserstoffperoxid gebracht wird, um diese in einem Zwischenschritt zunächst zu einem Metallhydroxid umzuwandeln, bevor die thermische Umwandlung erfolgt.

Weiterhin kann die Konvertierung der aufgebrachten Beschichtungszusammensetzung bei üblichen atmosphärischen Wassergehalten erfolgen.

Die Güte der nach dem erfindungsgemäßen Verfahren erzeugten Schicht kann weiterhin durch eine an den Konvertierungsschritt anschließende kombinierte Temperatur- und Gasbehandlung (mit H₂ oder O₂), Plasmabehandlung (Ar-, N₂-, O₂- oder H₂-Plasma), Mikrowellenbehandlung, Laser-Behandlung (mit Wellenlängen im UV-, VIS- oder IR-Bereich), UV-Licht, Infrarotstrahlung oder eine Ozon-Behandlung weiter verbessert werden.

Die nachfolgenden Beispiele sollen den Gegenstand der vorliegenden Erfindung weiter erläutern, ohne selbst beschränkend zu wirken.

### Erfindungsgemäßes Beispiel

### Synthese

In einem von Restfeuchte befreiten 30L Reaktor werden 1,30 kg Indium(III)-chlorid (InCl₃, 5,9 mol) unter Schutzgasatmosphäre durch Rühren in 17,38 kg getrocknetem Methanol suspendiert. Dimethylamin (2,57 kg, 57 mol) wird über einen Massflow-Controller (0,86 kg/h, ca. 4 h) bei Raumtemperatur zudosiert, wobei eine leicht exotherme Reaktion beobachtet werden kann. Danach wird das Reaktionsgemisch 2 h lang bei 50 °C temperiert, bis zu der Raumtemperatur abgekühlt und filtriert. Der Filterruckstand wird mit 4 x 500 mL getrocknetem Methanol gewaschen und 8 h lang am Vakuum (0,1 mbar) getrocknet. Das Material wird in siedendem Methanol gelöst und bei -20 °C auskristallisiert.

### Herstellung einer Formulierung

Der erhaltene Stoff wird mit einer Konzentration von 50 mg/mL in 1-Methoxy-2-propanol gelöst. Das erhaltende Konzentrat wird folgendermaßen formuliert: 1 Teil Konzentrat zu 2 Teilen 1-Methoxy-2-propanol zu einem Teil Ethanol. Dieser Formulierung werden weitere 3 Gew.-% Tetrahydrofurfurylalkohol (THFA) zugegeben. Alle verwendeten Lösungsmittel sind wasserfrei (< 200 ppm H₂0) und das Mischen erfolgt unter inerten Bedingungen (ebenfalls wasserfrei). Die erhaltene Formulierung wird final durch einen 200 nm PTFE-Filter gefiltert.

### Beschichtung

Ein dotiertes Siliciumsubstrat mit einer Kantenlänge von etwa 15 mm und mit einer ca. 200 nm dicken Siliciumoxid-Beschichtung und Fingerstrukturen aus ITO/Gold wurde mit 100 µl der oben genannten Formulierung benetzt. Dann erfolgt Spin Coating bei 2000 rpm (30 Sekunden). Das beschichtete Substrat wird direkt nach diesem Beschichtungsvorgang für 10 Minuten mit aus einer Quecksilberdampflampe stammenden UV-Strahlung im Wellenlängenbereich von 150 - 300 nm bestrahlt. Anschließend wird das Substrat eine Stunde auf einer Heizplatte bei einer Temperatur von 350 °C erhitzt. Nach der Konvertierung lässt sich in der Glove Box ein Wert für die Feldeffektbeweglichkeit (im linearen Bereich) µFET = 14 cm²/Vs bei 2 VDS bestimmen.

### Vergleichsbeispiel

### Synthese

In einem von Restfeuchte befreiten 500 ml-Glasrundkolben werden 5,0 g Indium(III)-chlorid (InCl₃, 22,5 mmol) unter Schutzgasatmosphäre durch Rühren in 250 ml getrocknetem Methanol gelöst, wobei ein Rückstand an InCl₃ von < 10 Gew.-% (bzgl. der Einwaage) zurückbleibt. Die Dosierung der Base Dimethylamin (5,0 g entsprechend 111 mmol) wird über einen Massflow-Controller sichergestellt und in der stöchiometrischen Menge bzgl. InCl₃ bei Raumtemperatur über einen Zeitraum von fünf Stunden zugegeben, wobei eine leicht exotherme Reaktion am Anfang beobachtet wurde. Anschließend wird die Lösung vollständig verdampft, der zurückbleibende Feststoff mit 250 ml getrocknetem Methanol aufgenommen, unter Schutzgas (N₂) filtriert, mehrfach (10 Vorgänge) mit getrocknetem Methanol gewaschen und unter Vakuum (< 10 mbar) für 12 h bei Raumtemperatur getrocknet. Die Produktausbeute betrug > 80 mol-% an Indium(III)-chlordimethoxid.

### Herstellen einer Formulierung

Der erhaltene Stoff wird mit einer Konzentration von 50 mg/mL in 1-Methoxy-2-propanol gelöst. Das erhaltende Konzentrat wird folgendermaßen formuliert: 1 Teil Konzentrat zu 2 Teilen 1-Methoxy-2-propanol zu einem Teil Ethanol. Dieser Formulierung werden weitere 3 Gew.-% Tetrahydrofurfurylalkohol (THFA) zugegeben. Alle verwendeten Lösungsmittel sind wasserfrei (<200 ppm H₂0) und das Mischen erfolgt unter inerten Bedingungen (ebenfalls wasserfrei). Die erhaltene Formulierung wird final durch einen 200 nm PTFE-Filter gefiltert.

### Beschichtung

Ein dotiertes Siliciumsubstrat mit einer Kantenlänge von etwa 15 mm und mit einer ca. 200 nm dicken Siliciumoxid-Beschichtung und Fingerstrukturen aus ITO/Gold wurde mit 100 µl der oben genannten Formulierung benetzt. Dann erfolgt Spin Coating bei 2000 rpm (30 Sekunden). Das beschichtete Substrat wird direkt nach diesem Beschichtungsvorgang für 10 Minuten mit aus einer Quecksilberdampflampe stammenden UV-Strahlung im Wellenlängenbereich von 150 - 300 nm bestrahlt. Anschließend wird das Substrat eine Stunde auf einer Heizplatte bei einer Temperatur von 350 °C erhitzt. Nach der Konvertierung lässt sich in der Glove Box ein Wert für die Feldeffektbeweglichkeit (im linearen Bereich) µFET = 8 cm²/Vs bei 2 VDS bestimmen.

## Patentansprüche

1. Flüssige Formulierung, herstellbar durch Lösen mindestens einer durch Umsetzen
- eines Indiumtrihalogenids InX₃ mit X = F, Cl, Br, I
- mit einem sekundären Amin der Formel R'₂NH mit R' =Alkyl,
o im molaren Verhältnis von 8 : 1 bis 20 : 1 in Bezug auf das Indiumtrihalogenid
- in Gegenwart eines Alkohols der generischen Formel ROH mit R = Alkyl
herstellbaren Indiumalkoxid-Verbindung in mindestens einem Lösemittel.

2. Formulierung nach Anspruch 1, **dadurch gekennzeichnet, dass** die Verbindung die generische Formel
[In₆(O)(OR)₁₂X₆]²⁻Aₘ^{z} (ROH)ₓ
mit R = Alkyl, X = F, Cl. Br, I, A = Kation, z = Wertigkeit des Kations, m·z = 2 und x = 0 bis 10 hat.

3. Formulierung nach Anspruch 2, **dadurch gekennzeichnet, dass** die Verbindung die generische Formel [In₆(O)(OMe)₁₂Cl₆]²⁻[NH₂R₂]⁺₂ (MeOH)₂ hat.

4. Formulierung nach einem der vorhergehenden Ansprüche, **dadurch gekennzeichnet, dass** sie die Indiumalkoxid-Verbindung zu 0,1 bis 10 Gew.-% bezogen auf die Gesamtmasse der Formulierung aufweist.

5. Formulierung nach einem der vorhergehenden Ansprüche, **dadurch gekennzeichnet, dass** das mindestens eine Lösemittel ausgewählt wird aus der Gruppe bestehend aus primären, sekundären, tertiären und aromatischen Alkoholen, der Ether, der Ester, der aromatischen Kohlenwasserstoffe und der Nitrile.

6. Formulierung nach einem der vorhergehenden Ansprüche, **dadurch gekennzeichnet, dass** das mindestens eine Lösemittel ausgewählt wird aus der Gruppe bestehend aus Methanol, Ethanol, Butanol, Tetrahydrofurfurylalkohol, Phenol, 2-Methoxyethanol, 1-Methoxy-2-Propanol, Tetrahydrofuran, Anisol, Butylacetat, 1-Methoxy-2-propylacetat (PGMEA), Ethylbenzoat, Ethylenglycoldiacetat, Ethyllactat, Butyllactat, Toluol, Xylol und Acetonitril.

7. Formulierung nach Anspruch 6, **dadurch gekennzeichnet, dass** sie mindestens drei Lösemittel aufweist, von denen eines ausgewählt wird aus der Gruppe bestehend aus Ethyllactat, Anisol, Tetrahydrofurfurylalkohol, Butylacetat, Ethylenglycoldiacetat und Ethylbenzoat und die anderen beiden unter SATP-Bedingungen eine Siedepunktsdifferenz von mindestens 30 °C aufweisen.

8. Formulierung nach einem der vorhergehenden Ansprüche, **dadurch gekennzeichnet, dass** sie die drei Lösemittel Ethanol, 1-Methoxy-2-propanol und Tetrahydrofurfurylalkohol umfasst.

9. Formulierung nach einem der vorhergehenden Ansprüche, **dadurch gekennzeichnet, dass** sie im Wesentlichen wasserfrei ist.

10. Verfahren zur Herstellung einer Formulierung nach einem der vorhergehenden Ansprüche, bei dem mindestens eine durch Umsetzen
- eines Indiumtrihalogenids InX₃ mit X = F, Cl, Br, I
- mit einem sekundären Amin der Formel R'₂NH mit R' =Alkyl,
- im molaren Verhältnis von 8:1 bis 20:1 in Bezug auf das Indiumtrihalogenid
- in Gegenwart eines Alkohols der generischen Formel ROH mit R = Alkyl herstellbare Indiumalkoxid-Verbindung mit mindestens einem Lösemittel vermischt wird.

11. Verwendung einer Formulierung nach einem der Ansprüche 1 bis 9 zur Herstellung Indiumoxid-haltiger Schichten.

12. Verwendung einer Formulierung nach einem der Ansprüche 1 bis 9 für die Herstellung halbleitender oder leitender Schichten für elektronische Bauteile, insbesondere zur Herstellung von (Dünnschicht)Transistoren, Dioden oder Solarzellen.

13. Verfahren zur Herstellung Indiumoxid-haltiger Schichten, bei dem eine Formulierung nach einem der Ansprüche 1 bis 9 auf ein Substrat aufgebracht und mit Wärme und/oder elektromagnetischer Strahlung konvertiert wird.

14. Verfahren nach Anspruch 13, **dadurch gekennzeichnet, dass** die aufgebrachte Formulierung mit Wärme und elektromagnetischer Strahlung konvertiert wird.

## Claims

1. Liquid formulation which can be produced by dissolving at least one indium alkoxide compound which can be prepared by reacting
- an indium trihalide InX₃ where X = F, Cl, Br, I
- with a secondary amine of the formula R'₂NH where R' = alkyl,
o in a molar ratio of from 8:1 to 20:1 to the indium trihalide
- in the presence of an alcohol of the generic formula ROH where R = alkyl
in at least one solvent.

2. Formulation according to Claim 1, **characterized in that** the compound has the generic formula
[In₆(O)(OR)₁₂X₆]²-Aₘ^{z} (ROH)ₓ
where R = alkyl, X = F, Cl. Br, I, A = cation, z = valency of the cation, m·z = 2 and x = 0 to 10.

3. Formulation according to Claim 2, **characterized in that** the compound has the generic formula [In₆(O)(OMe)₁₂Cl₆]²⁻[NH₂R²]⁺₂ (MeOH)₂.

4. Formulation according to any of the preceding claims, **characterized in that** it comprises the indium alkoxide compound in a proportion of from 0.1 to 10% by weight based on the total mass of the formulation.

5. Formulation according to any of the preceding claims, **characterized in that** the at least one solvent is selected from the group consisting of primary, secondary, tertiary and aromatic alcohols, ethers, esters, aromatic hydrocarbons and nitriles.

6. Formulation according to any of the preceding claims, **characterized in that** the at least one solvent is selected from the group consisting of methanol, ethanol, butanol, tetrahydrofurfuryl alcohol, phenol, 2-methoxyethanol, 1-methoxy-2-propanol, tetrahydrofuran, anisole, butyl acetate, 1-methoxy-2-propyl acetate (PGMEA), ethyl benzoate, ethylene glycol diacetate, ethyl lactate, butyl lactate, toluene, xylene and acetonitrile.

7. Formulation according to Claim 6, **characterized in that** it comprises at least three solvents of which one is selected from the group consisting of ethyl lactate, anisole, tetrahydrofurfuryl alcohol, butyl acetate, ethylene glycol diacetate and ethyl benzoate and the other two have a boiling point difference of at least 30°C under SATP conditions.

8. Formulation according to any of the preceding claims, **characterized in that** it comprises the three solvents ethanol, 1-methoxy-2-propanol and tetrahydrofurfuryl alcohol.

9. Formulation according to any of the preceding claims, **characterized in that** it is essentially water-free.

10. Process for producing a formulation according to any of the preceding claims, wherein at least one indium alkoxide compound which can be prepared by reacting
- an indium trihalide InX₃ where X = F, Cl, Br, I
- with a secondary amine of the formula R'₂NH where R' = alkyl,
- in a molar ratio of from 8:1 to 20:1 to the indium trihalide
- in the presence of an alcohol of the generic formula ROH where R = alkyl
is mixed with at least one solvent.

11. Use of a formulation according to any of Claims 1 to 9 for producing indium oxide-containing layers.

12. Use of a formulation according to any of Claims 1 to 9 for producing semiconducting or conductive layers for electronic components, in particular for producing (thin film) transistors, diodes or solar cells.

13. Process for producing indium oxide-containing layers, wherein a formulation according to any of Claims 1 to 9 is applied to a substrate and converted by means of heat and/or electromagnetic radiation.

14. Process according to Claim 13, **characterized in that** the applied formulation is converted by means of heat and electromagnetic radiation.

## Revendications

1. Formulation liquide, pouvant être préparée par dissolution d'au moins un composé de type alcoxyde d'indium, pouvant être préparé par transformation
- d'un trihalogénure d'indium InX₃ dans lequel X = F, Cl, Br, I
- avec une amine secondaire de formule R'₂NH dans laquelle R' = alkyle,
- dans un rapport molaire de 8:1 à 20:1 par rapport au trihalogénure d'indium
- en présence d'un alcool de formule générique ROH dans laquelle R = alkyle,
dans au moins un solvant.

2. Formulation selon la revendication 1, **caractérisée en ce que** le composé présente la formule générique
[In₆(O)(OR)₁₂X₆]²-Aₘ^{z}(ROH)ₓ
dans laquelle R = alkyle, X = F, Cl, Br, I, A = cation, z = valence du cation, m·z = 2 et x = 0 à 10.

3. Formulation selon la revendication 2, **caractérisée en ce que** le composé présente la formule générique [In₆(O)(OMe)₁₂Cl₆]²⁻[NH₂R₂]⁺²(MeOH)₂.

4. Formulation selon l'une quelconque des revendications précédentes, **caractérisée en ce qu'**elle présente le composé de type alcoxyde d'indium à raison de 0,1 à 10% en poids par rapport à la masse totale de la formulation.

5. Formulation selon l'une quelconque des revendications précédentes, **caractérisée en ce que** ledit au moins un solvant est choisi dans le groupe constitué par les alcools primaires, secondaires, tertiaires et aromatiques, les éthers, les esters, les hydrocarbures aromatiques et les nitriles.

6. Formulation selon l'une quelconque des revendications précédentes, **caractérisée en ce que** ledit au moins un solvant est choisi dans le groupe constitué par le méthanol, l'éthanol, le butanol, l'alcool tétrahydrofurfurylique, le phénol, le 2-méthoxyéthanol, le 1-méthoxy-2-propanol, le tétrahydrofuranne, l'anisol, l'acétate de butyle, l'acétate de 1-méthoxy-2-propyle (PGMEA), le benzoate d'éthyle, le diacétate d'éthylèneglycol, le lactate d'éthyle, le lactate de butyle, le toluène, le xylène et l'acétonitrile.

7. Formulation selon la revendication 6, **caractérisée en ce qu'**elle présente au moins trois solvants, parmi lesquels un est choisi dans le groupe constitué par le lactate d'éthyle, l'anisol, l'alcool tétrahydrofurfurylique, l'acétate de butyle, le diacétate d'éthylèneglycol et le benzoate d'éthyle et les deux autres présentent une différence de point d'ébullition dans les conditions SATP (conditions normales de température et de pression) d'au moins 30°C.

8. Formulation selon l'une quelconque des revendications précédentes, **caractérisée en ce qu'**elle comprend les trois solvants éthanol, 1-méthoxy-2-propanol et alcool tétrahydrofurfurylique.

9. Formulation selon l'une quelconque des revendications précédentes, **caractérisée en ce qu'**elle est essentiellement anhydre.

10. Procédé pour la préparation d'une formulation selon l'une quelconque des revendications précédentes, dans lequel un composé de type alcoxyde d'indium, pouvant être obtenu par transformation
- d'un trihalogénure d'indium InX₃ dans lequel X = F, Cl, Br, I
- avec une amine secondaire de formule R'₂NH dans laquelle R' = alkyle,
- dans un rapport molaire de 8:1 à 20:1 par rapport au trihalogénure d'indium
- en présence d'un alcool de formule générique ROH dans laquelle R = alkyle,
est mélangé avec au moins un solvant.

11. Utilisation d'une formulation selon l'une quelconque des revendications 1 à 9 pour la préparation de couches contenant de l'oxyde d'indium.

12. Utilisation d'une formulation selon l'une quelconque des revendications 1 à 9 pour la préparation de couches semi-conductrices ou conductrices pour des pièces électroniques, en particulier pour la fabrication de transistors (à couche mince), de diodes ou de cellules solaires.

13. Procédé pour la fabrication de couches contenant de l'oxyde d'indium, dans lequel une formulation selon l'une quelconque des revendications 1 à 9 est appliquée sur un substrat et convertie par de la chaleur et/ou un rayonnement électromagnétique.

14. Procédé selon la revendication 13, **caractérisé en ce que** la formulation appliquée est convertie par de la chaleur et un rayonnement électromagnétique.
